# EUROPÄISCHE PATENTSCHRIFT

(11) **EP 3 202 027 B1**
(45) Veröffentlichungstag und Bekanntmachung des Hinweises auf die Patenterteilung: **19.05.2021**
(21) Anmeldenummer: 15775392.2
(22) Anmeldetag: 14.09.2015
(51) Int. Cl.: H02M 7/00, H02M 1/088

(54) **LEISTUNGSMODUL, LEISTUNGSMODULGRUPPE, LEISTUNGSENDSTUFE SOWIE ANTRIEBSSYSTEM MIT EINER LEISTUNGSENDSTUFE**
POWER MODULE, POWER MODULE GROUP, POWER OUTPUT STAGE AND DRIVE SYSTEM COMPRISING A POWER OUTPUT STAGE
MODULE DE PUISSANCE, GROUPE DE MODULE DE PUISSANCE, ÉTAGE FINAL DE PUISSANCE ET SYSTÈME D'ENTRAÎNEMENT COMPRENANT UN ÉTAGE FINAL DE PUISSANCE

(30) Priorität: 02.10.2014 DE 102014219998
(43) Veröffentlichungstag der Anmeldung: 09.08.2017
(73) Patentinhaber: Vitesco Technologies GmbH, 30165 Hannover (DE)
(72) Erfinder: HOLZER, Harald, 93057 Regensburg (DE); MEYER, Frank, 93083 Obertraubling (DE); SCHMID, Thomas, 93051 Regensburg (DE); HAMMERL, Matthias, 93107 Wolkering (DE); HAUER, Gerald, 93180 Deuerling (DE)
(86) Internationale Anmeldenummer: PCT/EP2015/070935
(87) Internationale Veröffentlichungsnummer: WO 2016/050491

(56) Entgegenhaltungen:
- WO-A1-2013/128787
- WO-A1-2013/179547
- US-A1- 2011 062 491

## Beschreibung

Die vorliegende Erfindung betrifft ein Leistungsmodul, insbesondere ein Leistungsmodul zur Bereitstellung von einem Phasenstrom für eine Stromphase eines Elektromotors. Ferner betrifft die Erfindung eine Leistungsmodulgruppe mit zumindest zwei oben genannten Leistungsmodulen sowie eine Leistungsendstufe mit zumindest drei zuvor genannten Leistungsmodulgruppen. Außerdem betrifft die Erfindung ein Antriebssystem zum Antrieb eines Fahrzeugs mit zumindest einer zuvor genannten Leistungsendstufe.

Leistungsendstufen, insbesondere Leistungsendstufen von Antriebssystemen von Hybridelektro-/Elektrofahrzeugen zum Bereitstellen von Phasenströmen für Stromphasen eines Elektromotors, weisen Leistungstransistoren auf, die von externen Steuersignalen angesteuert Phasenströme mit Stromstärken von bis zu mehreren hundert oder gar über 500 Ampere einer nachgeschalteten Hochleistungslast, wie z. B. einem Elektromotor des Antriebssystems, bereitstellen beziehungsweise durchleiten. Bedingt durch physikalische Eigenschaften der Leistungsendstufen beziehungsweise der Leistungstransistoren in den Leistungsendstufen entstehen in den Leistungsendstufen parasitäre Induktionsströme, die zu Störungen in den Leistungsendstufen und gar zu Ausfällen der Leistungsendstufen führen können
Derartige Leistungsendstufen bzw. Leistungsmodule sind beispielsweise in US 2011/0062491 A1 und WO 2013/128787 A1 offenbart.

Die Aufgabe der vorliegenden Erfindung liegt somit darin, eine Möglichkeit bereitzustellen, die parasitären Induktionsströme bei den Leistungsendstufen zu reduzieren.

Diese Aufgabe wird durch den Gegenstand des unabhängigen Anspruchs 1 gelöst. Vorteilhafte Ausgestaltungen sind Gegenstand der Unteransprüche.

Gemäß einem ersten Aspekt der Erfindung wird ein Leistungsmodul, insbesondere ein Leistungsmodul zur Bereitstellung von einem Phasenstrom für eine Stromphase eines Elektromotors, bereitgestellt.

Dabei umfasst das Leistungsmodul einen Schaltungsträger mit einer Oberfläche.

Auf dieser Oberfläche weist das Leistungsmodul zumindest zwei erste Kontaktflächen zur Herstellung elektrischer Verbindung auf.

Das Leistungsmodul umfasst ferner zumindest zwei erste Leistungstransistoren, die jeweils auf den jeweiligen ersten Kontaktflächen verteilt angeordnet ist.

Dabei sind die zumindest zwei ersten Leistungstransistoren jeweils über eine Bodenkontaktfläche (auf Englisch "body-contact") unmittelbar mit den jeweiligen ersten Kontaktflächen elektrisch leitend verbunden.

Das Leistungsmodul weist auf der Oberfläche des Schaltungsträgers ferner eine zweite Kontaktfläche zur Herstellung elektrischer Verbindung auf.

Das Leistungsmodul umfasst ferner zumindest zwei zweite Leistungstransistoren, die allersamt auf der zweiten Kontaktfläche angeordnet sind.

Dabei sind die zumindest zwei zweiten Leistungstransistoren ebenfalls jeweils über eine Bodenkontaktfläche unmittelbar mit der zweiten Kontaktfläche elektrisch leitend verbunden.

Zudem weist das Leistungsmodul auf der Oberfläche des Schaltungsträgers zumindest zwei dritte Kontaktflächen auf, die ebenfalls zur Herstellung elektrischer Verbindung vorgesehen sind.

Dabei sind die zumindest zwei zweiten Leistungstransistoren jeweils über eine weitere Kontaktfläche (beziehungsweise Rückseitenkontaktfläche) mit einer der zumindest zwei dritten Kontaktflächen elektrisch leitend verbunden.

Die zumindest zwei ersten und die zumindest zwei dritten Kontaktflächen sind dabei in einer Richtung, insbesondere in der Längsrichtung, des Leistungsmoduls alternierend (zueinander abwechselnd) nacheinander angeordnet.

Die zweite Kontaktfläche ist zudem (in der oben genannten Richtung betrachtet) neben den zumindest zwei ersten und den zumindest zwei dritten Kontaktflächen angeordnet.

Der Schaltungsträger kann dabei als eine Leiterplatte, insbesondere als ein Keramiksubstrat, speziell als ein DBC-Substrat (auf Englisch "Direct Bonded Copper Substrat"), ausgebildet sein.

Dabei sind die zumindest zwei ersten Kontaktflächen und die zweite Kontaktfläche (vorzugsweise aber auch die zumindest zwei dritten Kontaktflächen) flächig ausgedehnt ausgebildet, so dass auf den jeweiligen Kontaktflächen die jeweiligen Leistungstransistoren über die jeweiligen gesamten Bodenkontaktflächen unmittelbar elektrisch leitend kontaktiert werden können.

Hierbei bedeutet der Begriff "unmittelbar", dass die entsprechende elektrische Verbindung zwischen einem Leistungstransistor und einer Kontaktfläche über die entsprechende Bodenkontaktfläche des Leistungstransistors über eine elektrisch leitende Schweiß- oder Klebeverbindung, oder über eine Lötverbindung lediglich mittels Lötpaste hergestellt ist. Zudem bedeutet eine elektrisch leitende Verbindung eine niederohmige beziehungsweise niederimpedante elektrische Verbindung, bei der der Widerstand beziehungsweise die Impedanz in dem Verbindungsweg vernachlässigbar gering ist.

Die zuvor genannte Bodenkontaktfläche ist eine flächig ausgedehnte Kontaktfläche auf der Bodenseite eines Leistungstransistors, die über 50%, insbesondere über 80%, der Gesamtfläche der Bodenseite abdeckt. Ein Beispiel derartiger Bodenkontaktfläche ist ein Bodenkontakt eines Nacktchips (Leistungstransistor).

Die zumindest zwei ersten Leistungstransistoren und die zumindest zwei zweiten Leistungstransistoren bilden jeweils die positivspannungsseitigen beziehungsweise die negativspannungsseitigen Leistungstransistoren oder umgekehrt die negativspannungsseitigen und die positivspannungsseitigen Leistungstransistoren des Leistungsmoduls.

Damit bilden die zumindest zwei ersten Kontaktflächen und die zumindest zwei dritten Kontaktflächen jeweils die positivspannungsseitigen beziehungsweise die negativspannungsseitigen Stromverbindungen oder die negativspannungsseitigen beziehungsweise die positivspannungsseitigen Stromverbindungen zu den jeweiligen Leistungstransistoren aus. Analog bildet die zweite Kontaktfläche die Stromverbindung zu der Stromphase des Elektromotors aus.

Dabei sind die zumindest zwei ersten und die zumindest zwei dritten Kontaktflächen in einer Bezugsrichtung, insbesondere in der Längsrichtung, des Leistungsmoduls betrachtet alternierend nacheinander angeordnet. Die zweite Kontaktfläche ist in der Bezugsrichtung des Leistungsmoduls betrachtet neben den zumindest zwei ersten und die zumindest zwei dritten Kontaktflächen angeordnet und erstreckt sich in der Bezugsrichtung des Leistungsmoduls von der Höhe einer an einem äußeren Rand befindlichen ersten Kontaktfläche bis zu der Höhe einer an einem anderen äußeren Rand befindlichen dritten Kontaktfläche.

Der Erfindung liegt der Gedanke zugrunde, dass zur Reduzierung der parasitären Induktionsströme vor allem die Gesamtinduktionsfläche reduziert werden müssen, die zwischen dem positivspannungsseitigen Leistungstransistor und dem negativspannungsseitigen Leistungstransistor einer und dergleichen Stromphase eines Leistungsmodules aufgespannt wird, und durch die der Strom von der positivspannungsseitigen Stromversorgungsleitung über den positivspannungsseitigen Leistungstransistor zu der Stromphase und wieder von der Stromphase über den negativspannungsseitigen Leistungstransistor zu der negativspannungsseitigen Stromversorgungsleitung fließt.

Um diese Gesamtinduktionsfläche zu reduzierten, werden anstelle eines einzigen großen (beziehungsweise groß dimensionierten) positivspannungsseitigen Leistungstransistors zumindest zwei kleinere (beziehungsweise klein dimensionierte) positivspannungsseitigen Leistungstransistoren und anstelle eines einzigen großen (beziehungsweise groß dimensionierten) negativspannungsseitigen Leistungstransistors zumindest zwei kleinere (beziehungsweise klein dimensionierte) negativspannungsseitigen Leistungstransistoren verwendet.

Durch das Ersetzen der großen Leistungstransistoren durch mehrere kleinere Leistungstransistoren können die elektrischen Verbindungen am und um die kleineren Leistungstransistoren, die zum Durchleiten von Dauerströmen ausgelegt sind, auch kleiner dimensioniert werden. Durch die kleineren Dimensionierungen bei den Leistungstransistoren und bei den elektrischen Verbindungen am und um die Leistungstransistoren entstehen parasitäre Induktionsströme mit geringeren Intensitäten, die in Summe geringer ausfallen als die der parasitären Induktionsströme, die bei einem Leistungsmodul mit den großen Leistungstransistoren entstehen würden.

Durch die alternierende Anordnung der ersten und der dritten Kontaktflächen, die die jeweiligen positiv- und negativspannungsseitigen Leistungstransistoren mit entsprechenden Stromversorgungsleitungen verbinden, werden die jeweiligen zwischen den jeweiligen positiv- und negativspannungsseitigen Leistungstransistoren aufgespannten Induktionsflächen und folglich auch die Gesamtinduktionsfläche des Leistungsmoduls weiter reduziert.

Zudem wird die Gesamtinduktionsfläche des Leistungsmoduls durch die Anordnung der zweiten Kontaktfläche, die die positivspannungsseitigen und die negativspannungsseitigen Leistungstransistoren miteinander und mit der Stromphase des Elektromotors elektrisch verbindet, neben den ersten und den dritten, also den positivspannungsseitigen und den negativspannungsseitigen, Kontaktflächen weiter reduziert.

Des Weiteren weist das Leistungsmodul auf der Oberfläche des Schaltungsträgers ferner zumindest eine Verbindungsfläche auf, die als eine Anformung an eine der zumindest zwei dritten Kontaktflächen ausgebildet ist und sich von der entsprechenden dritten Kontaktfläche weg erstreckt. Dabei erstreckt sich die zumindest eine Verbindungsfläche von der entsprechenden dritten Kontaktfläche bis zu einer anderen der zumindest zwei dritten Kontaktflächen und verbindet diese beiden dritten Kontaktflächen unmittelbar miteinander elektrisch.

Außerdem sind die zumindest eine Verbindungsfläche und die zumindest zwei dritten Kontaktflächen miteinander einstückig ausgebildet.

Mit den oben beschriebenen Leistungsmodulen kann somit eine Leistungsendstufe mit insgesamt geringen parasitären Induktionsströmen bereitgestellt werden.

Vorzugsweise ist jeweils eine der zumindest zwei zweiten Leistungstransistoren in der zuvor genannten Richtung betrachtet neben jeweils einer der zumindest zwei dritten Kontaktflächen angeordnet, so dass die aufgespannten Induktionsflächen von den jeweiligen Leistungstransistoren zu den entsprechenden dritten Kontaktflächen gering gehalten werden können.

Die zweite Kontaktfläche weist vorzugsweise zumindest zwei Kontaktbereiche auf, wobei sich jeweils einer der zumindest zwei Kontaktbereiche neben jeweils einem der zumindest zwei ersten Leistungstransistoren befindet. Die zumindest zwei ersten Leistungstransistoren sind jeweils über eine weitere Kontaktfläche mit den jeweiligen Kontaktbereichen elektrisch leitend verbunden.

Vorzugsweise sind die zumindest zwei Kontaktbereiche der zweiten Kontaktfläche und die zumindest zwei zweiten Leistungstransistoren in der Richtung des Leistungsmoduls alternierend nacheinander angeordnet.

Durch die zueinander alternierende Anordnung der ersten und der dritten Kontaktflächen sowie die zueinander alternierende Anordnung der zwei Kontaktbereiche der zweiten Kontaktfläche und der zumindest zwei zweiten Leistungstransistoren in der Richtung des Leistungsmoduls ist es möglich, jeweils einer der beiden ersten Leistungstransistoren (z. B. "high-side" Leistungstransistoren) und jeweils einer der beiden zweiten Leistungstransistoren (z. B. "low-side" Leistungstransistoren) paarweise zueinander alternierend und nebeneinander mit geringen Abständen zueinander anzuordnen. Dadurch werden die parasitären Induktionsströme nochmals reduziert.

Dabei ist die zumindest eine Verbindungsfläche vorzugsweise auf einer von der zweiten Kontaktfläche abgewandten (also von der zweiten Kontaktfläche aus betrachtet hinter den dritten Kontaktflächen liegende) Seite der Oberfläche des Schaltungsträgers angeordnet.

An dieser zumindest einen Verbindungsfläche kann ein durch eine der zumindest zwei dritten Kontaktflächen fließender Strom oder ein an einer zumindest zwei dritten Kontaktflächen anliegendes Spannungspotential gemessen werden.

Das Leistungsmodul umfasst vorzugsweise ferner eine vierte Kontaktfläche auf der Oberfläche des Schaltungsträgers, die als eine Anformung an der zweiten Kontaktfläche ausgebildet ist und sich von der zweiten Kontaktfläche weg in Richtung zu der zumindest einen Verbindungsfläche erstreckt.

Vorzugsweise sind die zweite und die vierte Kontaktfläche miteinander einstückig ausgebildet.

Über die vierte Kontaktfläche wird ein durch die zweite Kontaktfläche fließender Strom oder ein an der zweiten Kontaktfläche anliegendes Spannungspotential gemessen.

Gemäß einem weiteren Aspekt der Erfindung wird eine Leistungsmodulgruppe, insbesondere eine Leistungsmodulgruppe zur Bereitstellung von einem Phasenstrom für eine Stromphase eines Elektromotors bereitgestellt, die zumindest zwei zuvor beschriebene Leistungsmodule umfasst. Die Leistungsmodulgruppe umfasst ferner eine erste Stromschiene, die unmittelbar mit den jeweiligen zweiten Kontaktflächen der zumindest zwei Leistungsmodule elektrisch leitend verbunden ist und die zumindest zwei Leistungsmodule miteinander mechanisch verbindet.

Die Leistungsmodulgruppe umfasst vorzugsweise ferner eine zweite Stromschiene, die unmittelbar mit den jeweiligen ersten Kontaktflächen der zumindest zwei Leistungsmodule elektrisch leitend verbunden ist und die zumindest zwei Leistungsmodule miteinander mechanisch verbindet.

Ferner umfasst die Leistungsmodulgruppe vorzugsweise eine dritte Stromschiene, die mit den jeweiligen dritten Kontaktflächen der zumindest zwei Leistungsmodule elektrisch leitend verbunden ist und die zumindest zwei Leistungsmodule miteinander mechanisch verbindet.

Dabei sind die zuvor genannten drei Stromschienen flächig und länglich geformte vorzugsweise gestanzte elektrisch leitende Blechteile aus einem Metall oder einer Metalllegierung, insbesondre aus Kupfer oder einer Kupferlegierung.

Die Ausgestaltung mit der zweiten und der dritten Stromschiene ermöglicht zueinander alternierenden Stromanschlüssen zu den ersten und den dritten Kontaktflächen der beiden Leistungsmodule, was wiederum positiv auf die Reduzierung der parasitären Induktionsströme wirkt.

Die Leistungsmodulgruppe umfasst ferner eine elektrische Verbindung, die eine Verbindungsfläche eines der zumindest zwei Leistungsmodule unmittelbar mit einer der dritten Kontaktflächen eines anderen benachbarten der zumindest zwei Leistungsmodule elektrisch leitend verbindet.

Die Ausführung der Leistungsmodulgruppe mit zumindest zwei Leistungsmodulen ermöglicht geringe Herstellungs- und Wartungskosten bei den Leistungsmodulgruppen, da im Falle eines Defekts bei einem Leistungstransistor eines Leistungsmoduls anstelle einer gesamten Leistungsmodulgruppe lediglich das betroffene Leistungsmodul ausgetauscht werden muss.

Zudem ermöglichen die zweite und die dritte Stromschiene und die elektrische Verbindung zwischen den beiden Leistungsmodulen gemeinsame Inter- und Intra-Substrat-Bondverbindungen, die in einem einzigen Bondvorgang hergestellt werden können.

Gemäß noch einem weiteren Aspekt der Erfindung wird eine Leistungsendstufe, insbesondere eine Leistungsendstufe zum Bereitstellen von Phasenströmen für Stromphasen eines Elektromotors, bereitgestellt, die zumindest drei zuvor beschriebene Leistungsmodulgruppen umfasst.

Dabei sind die ersten Stromschienen der zumindest drei Leistungsmodulgruppen eingerichtet, die Leistungsmodulgruppen mit den jeweiligen Stromphasen des Elektromotors elektrisch leitend zu verbinden.

Die Leistungsendstufe umfasst ferner einen Leistungskondensator, der einen ersten Elektrodenanschluss und einen zweiten Elektrodenanschluss aufweist und über den ersten Elektrodenanschluss mit den jeweiligen zweiten Stromschienen der zumindest drei Leistungsmodulgruppen und über den zweiten Elektrodenanschluss mit den jeweiligen dritten Stromschienen der zumindest drei Leistungsmodulen elektrisch leitend verbunden.

Gemäß noch einem weiteren Aspekt der Erfindung wird ein Antriebssystem zum Antrieb eines Fahrzeugs, insbesondere eines Hybridelektro-/Elektrofahrzeugs, bereitgestellt, das zumindest einen Elektromotor zum Antrieb des Fahrzeugs und zumindest eine zuvor beschriebene Leistungsendstufe zum Bereitstellen von Phasenströmen für die Stromphasen des zumindest einen Elektromotors umfasst.

Vorteilhafte Ausgestaltungen des oben beschriebenen Leistungsmoduls sind, soweit im Übrigen auf die oben beschriebene Leistungsmodulgruppe, die oben genannte Leistungsendstufe oder auf das oben genannte Antriebssystem übertragbar, auch als vorteilhafte Ausgestaltungen der Leistungsmodulgruppe, der Leistungsendstufe beziehungsweise des Antriebssystems anzusehen.

Im Folgenden werden beispielhafte Ausführungsformen der Erfindung Bezug nehmend auf folgende Figuren näher erläutert. Dabei zeigen:
- Figur 1: in einer schematischen Darstellung ein Leistungsmodul gemäß einer Ausführungsform der Erfindung;
- Figur 2: in einer schematischen Darstellung eine Leistungsmodulgruppe mit einer in Figur 1 dargestellten Leistungsmodul;
- Figur 3: in einer schematischen Darstellung eine Leistungsendstufe mit drei in Figur 2 dargestellten Leistungsmodulgruppen.

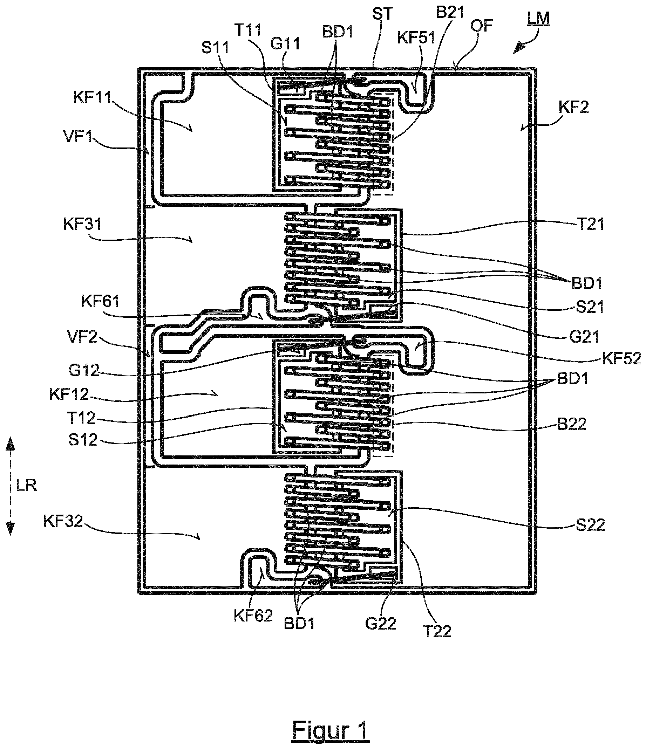

Figur 1 zeigt ein Leistungsmodul LM zum Bereitstellen von einem Phasenstrom für eine Stromphase eines in der Figur nicht dargestellten Elektromotors in einer schematischen Draufsicht.

Das Leistungsmodul LM umfasst einen Schaltungsträger ST, der in dieser Ausführungsform als ein Keramiksubstrat (DBC-Substrat) ausgebildet ist. Der Schaltungsträger ST weist eine Oberfläche OF auf, auf der eine erste Gruppe von zwei ersten elektrischen Kontaktflächen KF11, KF12, eine zweite elektrische Kontaktfläche KF2 sowie eine zweite Gruppe von zwei dritten elektrischen Kontaktflächen KF31, KF32 aus Kupfer als Teil der Leiterbahnstruktur aufgetragen sind.

Dabei sind die ersten und die dritten Kontaktflächen KF11, KF12 und KF31, KF32 zueinander alternierend auf der (von dem Betrachter der Figur aus gesehen) linken Hälfte der Oberfläche OF des Schaltungsträgers ST und in dessen Längsrichtung LR nacheinander angeordnet. Die ersten und die dritten Kontaktflächen KF11, KF12 und KF31, KF32 sind flächig ausgedehnt ausgebildet und weisen ungefähr die gleichen Flächengrößen auf. Gemeinsam decken sie über 70% der linken Hälfte der Oberfläche OF ab.

Die zweite Kontaktfläche KF2 ist in der Längsrichtung LR betrachtet unmittelbar neben den ersten und den dritten Kontaktflächen KF11, KF12, KF31, KF32 und somit auf der (von dem Betrachter der Figur aus gesehen) rechten Hälfte der Oberfläche OF angeordnet. Dabei erstreckt sich die zweite Kontaktfläche KF2 in der Längsrichtung LR von einem Ende bis zu einem anderen Ende des Schaltungsträgers ST beziehungsweise von einer am äußeren Rand der Oberfläche OF befindlichen ersten Kontaktfläche KF11 bis zu einer ebenfalls am äußeren Rand der Oberfläche OF befindlichen dritten Kontaktfläche KF32. Die zweite Kontaktfläche KF2 ist ebenfalls flächig ausgedehnt ausgebildet und deckt über 80% der rechten Hälfte der Oberfläche OF ab.

Die zwei ersten Kontaktflächen KF11, KF12 dienen zur Herstellung elektrischer Verbindungen von einer in der Figur nicht dargestellten positiven Stromversorgungsleitung zu den Drain-Anschlüssen von zwei nachfolgend zu beschreibenden ersten, positivspannungsseitigen Leistungs-MOSFETs T11, T12.

Die zweite Kontaktfläche KF2 dient zur Herstellung elektrischer Verbindung von dem Leistungsmodul LM zu einer Stromphase des Elektromotors, wobei diese die Source-Anschlüsse S11, S12 der zuvor genannten positivspannungsseitigen Leistungs-MOSFETs T11, T12 und die Drain-Anschlüsse von nachfolgend zu beschreibenden zweiten, negativspannungsseitigen Leistungs-MOSFETs T21, T22 sowie die Stromphase des Elektromotors miteinander elektrisch verbindet.

Die zwei dritten Kontaktflächen KF31, KF32 dienen analog zu den ersten Kontaktflächen KF11, KF12 zur Herstellung elektrischer Verbindungen von den jeweiligen Source-Anschlüssen S21, S22 der zweiten Leistungs-MOSFETs T21, T22 zu einer in der Figur nicht dargestellten negativen Stromversorgungsleitung.

Das Leistungsmodul LM weist auf der Oberfläche OF des Schaltungsträgers ST ferner zwei Verbindungsflächen VF1, VF2 auf, die jeweils als eine Anformung der jeweiligen dritten Kontaktflächen KF31, KF32 mit den jeweiligen dritten Kontaktflächen KF31, KF32 einstückig ausgebildet sind und sich von den jeweiligen dritten Kontaktflächen KF31, KF32 weg in Längsrichtung LR des Schaltungsträgers ST erstrecken. Dabei erstreckt sich eine der beiden Verbindungsflächen VF2 von der einen dritten Kontaktfläche KF32 bis zu der anderen dritten Kontaktfläche KF31 und verbindet diese beiden dritten Kontaktflächen KF31, KF32 miteinander einstückig.

Die beiden Verbindungsflächen VF1, VF2 befinden sich auf einem von der zweiten Kontaktfläche KF2 abgewandten Bereich der Oberfläche OF.

Zwischen den jeweiligen ersten Kontaktflächen KF11, KF12 und der zweiten Kontaktfläche KF2 weist das Leistungsmodul LM jeweils eine fünfte Kontaktfläche KF51, KF52 auf, die zur Herstellung elektrischer Verbindungen von in der Figur nicht dargestellten externen Steuersignalverbindungen zu den jeweiligen Gate-Anschlüssen G11, G12 der positivspannungsseitigen Leistungs-MOSFETs T11, T12 eingerichtet sind.

Zwischen den jeweiligen dritten Kontaktflächen KF31, KF32 und der zweiten Kontaktfläche KF2 weist das Leistungsmodul LM jeweils eine sechste Kontaktfläche KF61, KF62 auf, die analog zu den fünften Kontaktflächen KF51, KF52 zur Herstellung elektrischer Verbindungen von in der Figur nicht dargestellten externen Steuersignalverbindungen zu den jeweiligen Gate-Anschlüssen G21, G22 der negativspannungsseitigen Leistungs-MOSFETs T21, T22 eingerichtet sind. Optional ist eine der sechsten Kontaktflächen KF61 von der zweiten Kontaktfläche KF2 weg in Richtung zu einer der Verbindungsflächen VF2 lang erstreckend ausgebildet und weist einen Kontaktbereich auf, über den ein externes Steuersignal zum Ansteuern der negativspannungsseitigen Leistungs-MOSFETs T21, T22 angelegt werden kann.

Das Leistungsmodul LM umfasst ferner die zwei zuvor genannten positivspannungsseitigen Leistungs-MOSFETs T11, T12, die als Nacktchips (auf Englisch "Bare Die") ausgebildet sind.

Auf der jeweiligen Bodenseite weisen die positivspannungsseitigen Leistungs-MOSFETs T11, T12 den Drain-Anschluss auf, der als ein flächig ausgedehnter Bodenkontakt (auf Englisch "Body Contact") ausgebildet ist.

Auf der jeweiligen Rückseite weisen die positivspannungsseitigen Leistungs-MOSFETs T11, T12 den Source-Anschluss S11, S12, der als ein flächig ausgedehnter Rückseitenkontakt ausgebildet ist, sowie den Gate-Anschluss G11, G12, auf.

In Figur 1 sind die Drain-Anschlüsse der positivspannungsseitigen Leistungs-MOSFETs T11, T12 nicht sichtbar, da diese sich auf der Bodenseite und somit auf der von dem Betrachter der Figur entgegengesetzten Seite der jeweiligen Leistungs-MOSFETs T11, T12 befinden.

Die zwei positivspannungsseitigen Leistungs-MOSFETs T11, T12 sind jeweils direkt auf einer der jeweiligen ersten Kontaktflächen KF11, K12 angeordnet und über ihre jeweiligen Drain-Anschlüsse mit den jeweiligen ersten Kontaktflächen KF11, KF12 lediglich mittels Lötpasten direkt elektrisch leitend verbunden (mittels Nacktchipmontage, auf Englisch "Chip on Board").

Über die jeweiligen Source-Anschlüsse S11, S12 sind die Leistungs-MOSFETs T11, T12 mittels Bondverbindungen BD1 mit jeweils einem von zwei Kontaktbereichen B21, B22 der zweiten Kontaktfläche KF2 elektrisch leitend verbunden, wobei die beiden Kontaktbereiche B21, B22 sich jeweils neben dem jeweiligen Leistungs-MOSFETs T11, T12 befinden. Über die jeweiligen Gate-Anschlüsse G11, G12 sind die Leistungs-MOSFETs T11, T12 mittels weiterer Bondverbindungen BD1 jeweils mit einer der beiden fünften Kontaktflächen KF51, KF52 elektrisch leitend verbunden.

Das Leistungsmodul LM umfasst ferner die zwei zuvor genannten negativspannungsseitigen Leistungs-MOSFETs T21, T22, die ebenfalls als Nacktchips ausgebildet sind und auf der jeweiligen Bodenseite als flächig ausgedehnten Bodenkontakt den Drain-Anschluss und auf der jeweiligen Rückseite als flächig ausgedehnten Rückseitenkontakt den Source-Anschluss S21, S22 und den Gate-Anschluss G21, G22 aufweisen. In Figur 1 sind die Drain-Anschlüsse der negativspannungsseitigen Leistungs-MOSFETs T21, T22 ebenfalls nicht sichtbar, da diese sich auf der Bodenseite und somit auf der von dem Betrachter der Figur entgegengesetzten Seite der jeweiligen Leistungs-MOSFETs T21, T22 befinden.

Die zwei negativspannungsseitigen Leistungs-MOSFETs T21, T22 sind jeweils direkt auf der zweiten Kontaktfläche KF2 angeordnet und über ihre jeweiligen Drain-Anschlüsse mit der zweiten Kontaktfläche KF2 lediglich mittels Lötpasten direkt elektrisch leitend verbunden. Dabei befinden sich die beiden negativspannungsseitigen Leistungs-MOSFETs T21, T22 jeweils (in der Längsrichtung LR des Leistungsmoduls LM betrachtet) neben einer der beiden dritten Kontaktflächen KF31, KF32. Über die jeweiligen Source-Anschlüsse S21, S22 sind die negativspannungsseitigen Leistungs-MOSFETs T21, T22 mittels Bondverbindungen BD1 jeweils mit einer der beiden dritten Kontaktflächen KF31, KF32 elektrisch leitend verbunden. Über die jeweiligen Gate-Anschlüsse G21, G22 sind die Leistungs-MOSFETs T21, T22 mittels Bondverbindungen BD1 jeweils mit einer der beiden sechsten Kontaktflächen KF61, KF62 elektrisch leitend verbunden.

In der Längsrichtung LR betrachtet sind die beiden negativspannungsseitigen Leistungs-MOSFETs T21, T22 und die zuvor genannten zwei Kontaktbereiche B21, B22 der zweiten Kontaktfläche KF2 alternierend nacheinander angeordnet.

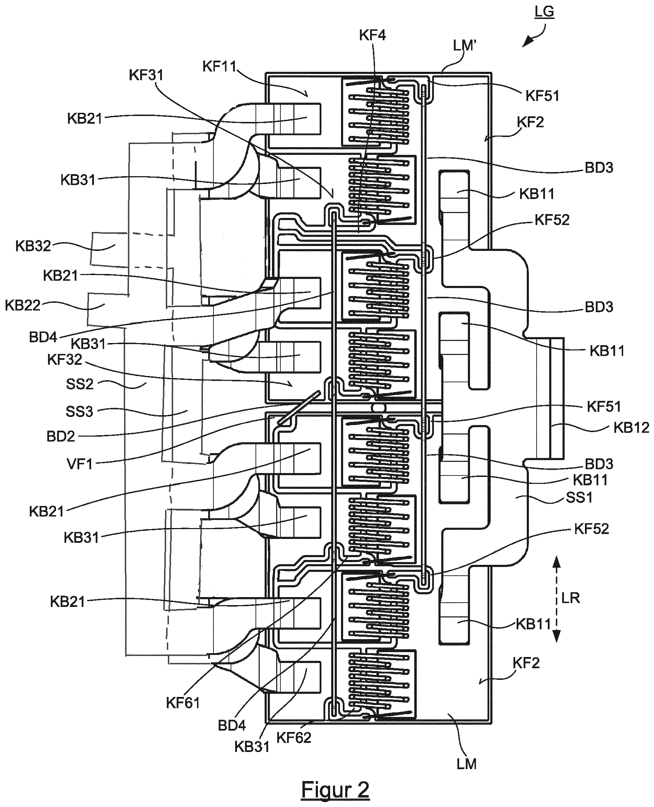

Figur 2 zeigt eine Leistungsmodulgruppe LG zum Bereitstellen von einem Phasenstrom für eine Stromphase des zuvor genannten Elektromotors.

Die Leistungsmodulgruppe LG umfasst zwei Leistungsmodule LM, LM', davon ein Leistungsmodul LM bereits in Figur 1 dargestellt ist. Ein weiteres Leistungsmodul LM' unterscheidet sich von dem in Figur 1 dargestellten Leistungsmodul LM unter anderem dadurch, dass dieses nur eine Verbindungsfläche VF2 aufweist, die zwischen den beiden dritten Kontaktflächen KF31, KF32 und mit den beiden dritten Kontaktflächen KF31, KF32 einstückig ausgebildet ist.

Die beiden Leistungsmodule LM, LM' sind in deren Längsrichtung LR betrachtet nacheinander angeordnet.

So wie in Figur 2 sichtbar ist, weist das Leistungsmodul LM' optional ferner eine vierte Kontaktfläche KF4 auf, die auf der Oberfläche OF des Schaltungsträgers ST als eine Anformung an der zweiten Kontaktfläche KF2 ausgebildet ist und sich von der zweiten Kontaktfläche KF2 und zwischen einer ersten Kontaktfläche KF12 und einer dieser ersten Kontaktfläche KF12 benachbarten dritten Kontaktfläche KF31 in Richtung zu der die beiden dritten Kontaktflächen KF31, KF32 miteinander einstückig verbindenden Verbindungsfläche VF2 erstreckt. Dabei endet die vierte Kontaktfläche KF4 kurz vor der Verbindungsfläche VF2 und somit ist von der Verbindungsfläche VF2 elektrisch isoliert.

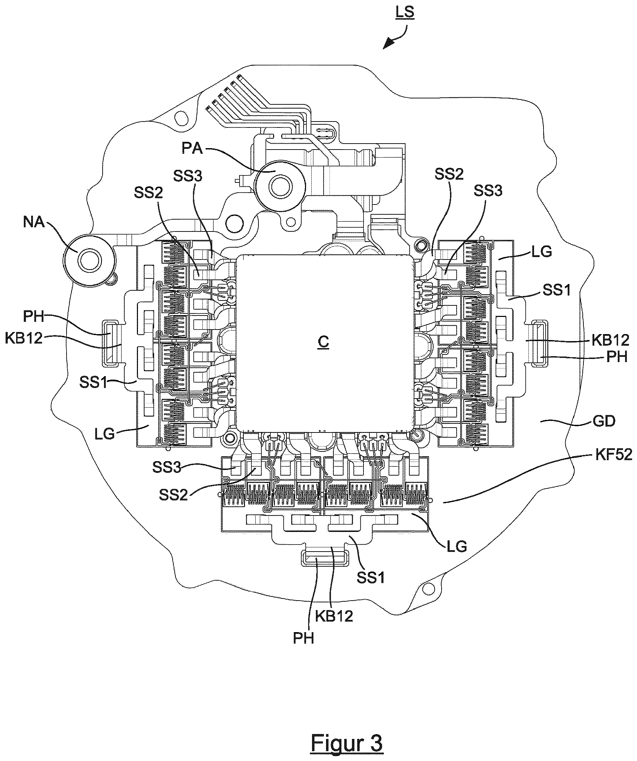

Die Leistungsmodulgruppe LG umfasst ferner eine erste Stromschiene SS1, die im Wesentlichen kammförmig ausgebildet ist und vier freiliegenden Kontaktbeine KB11 auf einer Seite und ein fünftes Kontaktbein KB12 auf der anderen Seite der Stromschiene SS1 aufweist. Über jeweils zwei der vier freiliegenden Kontaktbeine KB11 auf der einen Seite ist die erste Stromschiene SS1 mit den jeweiligen zweiten Kontaktflächen KF2 der beiden Leistungsmodule LM, LM' mittels Lötpasten elektrisch leitend und mechanisch verbunden. Das fünfte Kontaktbein KB12 der ersten Stromschiene SS1 dient zur Herstellung elektrischer Verbindung von der Leistungsmodulgruppe LG zu der Stromphase des Elektromotors (siehe Figur 3).

Die Leistungsmodulgruppe LG umfasst ferner eine zweite Stromschiene SS2, die ebenfalls kammförmig ausgebildet ist und vier freiliegenden Kontaktbeine KB21 auf einer Seite und ein fünftes Kontaktbein KB22 auf der anderen Seite aufweist. Über die vier Kontaktbeine KB21 auf der einen Seite ist die zweite Stromschiene SS2 mit den jeweiligen ersten Kontaktflächen KF11, KF2 der beiden Leistungsmodule LM, LM' mittels Lötpasten mechanisch und elektrisch leitend verbunden. Das fünfte Kontaktbein KB22 der zweiten Stromschiene SS2 dient zur Herstellung einer elektrischen Verbindung von der Leistungsmodulgruppe LG zu einer externen positiven Stromversorgungsleitung (siehe Figur 3) .

Die Leistungsmodulgruppe LG umfasst ferner eine dritte Stromschiene SS3, die analog zu der zweiten Stromschiene SS2 ebenfalls vier freiliegenden Kontaktbeine KB31 auf einer Seite und ein fünftes Kontaktbein KB32 auf der anderen Seite aufweist. Über die vier Kontaktbeine KB31 auf der einen Seite ist die dritte Stromschiene SS3 mit den jeweiligen dritten Kontaktflächen KF31, K32 der beiden Leistungsmodule LM, LM' mittels Lötpasten elektrisch leitend und mechanisch verbunden. Das fünfte Kontaktbein KB32 der dritten Stromschiene SS3 dient zur Herstellung einer elektrischen Verbindung von der Leistungsmodulgruppe LG zu einer externen negativen Stromversorgungsleitung (siehe Figur 3) .

Die am äußeren Rand befindliche Verbindungsfläche VF1 des einen Leistungsmoduls LM ist über eine Bondverbindung BD2 mit der ebenfalls am äußeren Rand befindlichen dritten Kontaktfläche KF32 des anderen Leistungsmoduls LM' elektrisch leitend verbunden. Diese Bondverbindung BD2 dient zum Ausgleich der Spannungspotentiale an den jeweiligen dritten Kontaktflächen KF31, KF32 der beiden Leistungsmodule LM, LM', so dass die durch die dritten Kontaktflächen KF31, KF2 der beiden Leistungsmodule LM, LM' fließenden Source-Ströme der niederspannungsseitigen Leistungstransistoren T21, T22 der beiden Leistungsmodule LM, LM' oder das an den Source-Anschlüssen S21, S22 der beiden niederspannungsseitigen Leistungstransistoren T21, T22 anliegende Spannungspotential an einem beliebigen Messpunkt auf einer der dritten Kontaktflächen KF31, KF32 oder einer der Verbindungsflächen VF1, VF2 der beiden Leistungsmodule LM, LM' gemessen werden können.

Die fünften Kontaktflächen KF51, KF52 der beiden Leistungsmodule LM, LM' sind über weitere Bondverbindungen BD3 miteinander elektrisch leitend verbunden. Über diese Bondverbindungen BD3 wird das Ansteuersignal zum Steuern der positivspannungsseitigen Leistungstransistoren T11, T12 an deren jeweiligen Gate-Anschlüssen G11, G12 angelegt.

Analog sind die sechsten Kontaktflächen KF61, KF62 der beiden Leistungsmodule LM, LM' sind über weitere Bondverbindungen BD4 miteinander elektrisch leitend verbunden. Über diese Bondverbindungen BD4 wird das Ansteuersignal zum Steuern der negativspannungsseitigen Leistungstransistoren T21, T22 an deren jeweiligen Gate-Anschlüssen G21, G22 angelegt.

Figur 3 zeigt eine Leistungsendstufe LS zum Bereitstellen von drei Phasenströmen für drei Stromphasen des zuvor genannten Elektromotors, die auf einem Gehäusedeckel GD des Elektromotors implementiert ist.

Die Leistungsendstufe LS umfasst einen Leistungskondensator C, der auf dem Gehäusedeckel GD mittig angeordnet und befestigt ist.

Der Leistungskondensator C umfasst einen ersten, positiven Elektrodenanschluss (in der Figur nicht sichtbar) und einen zweiten, negativen Elektrodenanschluss (in der Figur nicht sichtbar). Über den positiven Elektrodenanschluss ist der Leistungskondensator C mit einem positiven Stromanschluss PA der Leistungsendstufe LS elektrisch verbunden, der an einer in der Figur nicht dargestellten positiven Stromversorgungsleitung elektrisch angeschlossen wird. Über den negativen Elektrodenanschluss ist der Leistungskondensator C mit einem negativen Stromanschluss NA der Leistungsendstufe LS elektrisch verbunden, der an einer ebenfalls in der Figur nicht dargestellten negativen Stromversorgungsleitung elektrisch angeschlossen wird.

Die Leistungsendstufe LS umfasst ferner drei in Figur 2 dargestellte Leistungsmodulgruppen LG zur Bereitstellung von den jeweiligen drei Phasenströmen, wobei die drei Leistungsmodulgruppen LG um den Leistungskondensator C herum verteilt auf dem Gehäusedeckel GD angeordnet und befestigt sind.

Die drei Leistungsmodulgruppen LG sind jeweils über das freiliegende fünfte Kontaktbein KB22 der jeweiligen zweiten Stromschienen SS2 mit dem positiven Elektrodenanschluss des Leistungskondensators C und somit mit dem positiven Stromanschluss PA der Leistungsendstufe LS elektrisch leitend verbunden.

Analog sind die drei Leistungsmodulgruppen LG jeweils über das fünfte Kontaktbein KB32 der jeweiligen dritten Stromschienen SS3 mit dem negativen Elektrodenanschluss des Leistungskondensators C und somit mit dem negativen Stromanschluss NA der Leistungsendstufe LS elektrisch leitend verbunden.

Ferner sind die drei Leistungsmodulgruppen LG jeweils über das fünfte Kontaktbein KB12 der jeweiligen ersten Stromschienen SS1 mit einem von drei Phasenanschlüssen PH der Leistungsendstufe LS elektrisch leitend verbunden, die jeweils mit einer der drei Stromphasen des Elektromotors elektrisch verbunden werden.

## Patentansprüche

1. Leistungsmodul (LM, LM'), insbesondere zur Bereitstellung von einem Phasenstrom für einen Elektromotor, mit folgenden Merkmalen:
- einem Schaltungsträger (ST) mit einer Oberfläche (OF);
- zumindest zwei ersten Kontaktflächen (KF11, KF12) auf der Oberfläche (OF), auf denen jeweils ein ersten, eine Bodenkontaktfläche aufweisender Leistungstransistor (T11, T12) unmittelbar angeordnet ist, der jeweils über seine Bodenkontaktfläche mit der jeweiligen ersten Kontaktfläche (KF11, KF12) elektrisch leitend verbunden ist;
- einer zweiten Kontaktfläche (KF2) auf der Oberfläche (OF), auf der zumindest zwei zweite, eine Bodenkontaktfläche aufweisende Leistungstransistoren (T21, T22) unmittelbar angeordnet sind, die jeweils über ihre Bodenkontaktfläche mit der zweiten Kontaktfläche (KF2) elektrisch leitend verbunden sind;
- zumindest zwei dritten Kontaktflächen (KF31, KF32) auf der Oberfläche (OF), wobei die zumindest zwei zweiten Leistungstransistoren (T21, T22) jeweils einen flächig ausgedehnten Rückseitenkontakt (S21, S22) aufweisen, über den sie jeweils mit einer der zumindest zwei dritten Kontaktflächen (KF31, KF32) elektrisch leitend verbunden sind;
- wobei die zumindest zwei ersten (KF11, KF12) und die zumindest zwei dritten (KF31, KF32) Kontaktflächen in einer Bezugsrichtung (LR) des Leistungsmoduls alternierend nacheinander angeordnet sind, und die zweite Kontaktfläche (KF2) neben den zumindest zwei ersten (KF11, KF12) und den zumindest zwei dritten (KF31, KF32) Kontaktflächen angeordnet ist,
**dadurch gekennzeichnet, dass**
- das Leistungsmodul (LM, LM') ferner zumindest eine Verbindungsfläche (VF2) auf der Oberfläche (OF) umfasst, die als eine Anformung an einer der zumindest zwei dritten Kontaktflächen (KF31) sich von der entsprechenden dritten Kontaktfläche (KF31) weg bis zu einer anderen der zumindest zwei dritten Kontaktflächen (KF32) erstreckt und diese beiden dritten Kontaktflächen (KF31, KF32) unmittelbar miteinander elektrisch leitend verbindet;
- wobei die zumindest eine Verbindungsfläche (VF2) und die zumindest zwei dritten Kontaktflächen (KF31, KF32) miteinander einstückig ausgebildet sind.

2. Leistungsmodul (LM, LM') nach Anspruch 1, wobei jeweils einer der zumindest zwei zweiten Leistungstransistoren (T21, T22) neben jeweils einer der zumindest zwei dritten Kontaktflächen (KF31, KF32) angeordnet sind.

3. Leistungsmodul (LM, LM') nach Anspruch 1 oder 2,
- wobei die zweite Kontaktfläche (KF2) zumindest zwei Kontaktbereiche (B21, B22) aufweist;
- wobei sich jeweils einer der zumindest zwei Kontaktbereiche (B21, B22) neben jeweils einem der zumindest zwei ersten Leistungstransistoren (T11, T12) befindet und die zumindest zwei ersten Leistungstransistoren (T11, T12) jeweils einen flächig ausgedehnten Rückseitenkontakt (S11, S12) aufweisen, über den sie jeweils mit einem der zumindest zwei Kontaktbereiche (B21, B22) elektrisch leitend verbunden sind.

4. Leistungsmodul (LM, LM') nach Anspruch 3, wobei die zumindest zwei ersten Kontaktbereiche (B21, B22) und die zumindest zwei zweiten Leistungstransistoren (T21, T22) in der Bezugsrichtung (LR) des Leistungsmoduls alternierend nacheinander angeordnet sind.

5. Leistungsmodul (LM') nach einem der vorangehenden Ansprüche, ferner umfassend eine vierte Kontaktfläche (KF4) auf der Oberfläche (OF), die als eine Anformung an der zweiten Kontaktfläche (KF2) sich von der zweiten Kontaktfläche (KF2) weg in Richtung zu der zumindest einen Verbindungsfläche (VF2) erstreckt.

6. Leistungsmodul (LM, LM') nach Anspruch 5, wobei die zweite (KF2) und die vierte (KF4) Kontaktfläche miteinander einstückig ausgebildet sind.

7. Leistungsmodulgruppe (LG), insbesondre zur Bereitstellung von einem Phasenstrom für einen Elektromotor, mit folgenden Merkmalen:
- zumindest zwei Leistungsmodule (LM, LM') nach einem der vorangehenden Ansprüche;
- eine erste Stromschiene (SS1), die unmittelbar mit den jeweiligen zweiten Kontaktflächen (KF2) der zumindest zwei Leistungsmodule (LM, LM') elektrisch leitend verbunden ist und die zumindest zwei Leistungsmodule (LM, LM') miteinander mechanisch verbindet.

8. Leistungsmodulgruppe (LG) nach Anspruch 7, die ferner eine zweite Stromschiene (SS2) aufweist, die unmittelbar mit den jeweiligen ersten Kontaktflächen (KF11, KF12) der zumindest zwei Leistungsmodule (LM, LM') elektrisch leitend verbunden ist und die zumindest zwei Leistungsmodule (LM, LM') miteinander mechanisch verbindet.

9. Leistungsmodulgruppe (LG) nach Anspruch 7 oder 8, die ferner eine dritte Stromschiene (SS3) aufweist, die mit den jeweiligen dritten Kontaktflächen (KF31, KF32) der zumindest zwei Leistungsmodule (LM, LM') elektrisch leitend verbunden ist und die zumindest zwei Leistungsmodule (LM, LM') miteinander mechanisch verbindet.

10. Leistungsmodulgruppe (LG) nach einem der Ansprüche 7 bis 9, die ferner zumindest eine elektrische Verbindung (BD) aufweist, die die eine Verbindungsfläche (VF2) eines der zumindest zwei Leistungsmodule (LM) unmittelbar mit einer der dritten Kontaktflächen (KF32) eines anderen der zumindest zwei Leistungsmodule (LM') elektrisch leitend verbindet.

11. Leistungsendstufe (LS), insbesondere zum Bereitstellen von Phasenströmen für Stromphasen eines Elektromotors, mit folgenden Merkmalen:
- zumindest drei Leistungsmodulgruppen (LG) nach einem der Ansprüche 7 bis 10;
- einem Leistungskondensator (C), der einen ersten Elektrodenanschluss und einen zweiten Elektrodenanschluss aufweist und über den ersten Elektrodenanschluss mit den jeweiligen zweiten Stromschienen (SS2) der zumindest drei Leistungsmodulgruppen (LG) und über den zweiten Elektrodenanschluss mit den jeweiligen dritten Stromschienen (SS3) der zumindest drei Leistungsmodulgruppen (LG) elektrisch leitend verbunden ist.

12. Antriebssystem zum Antrieb eines Fahrzeugs, das zumindest einen Elektromotor zum Antrieb des Fahrzeugs und zumindest eine Leistungsendstufe (LS) nach Anspruch 11 zum Bereitstellen von Phasenströmen für den zumindest einen Elektromotor umfasst.

## Claims

1. Power module (LM, LM'), specifically for the delivery of a phase current to an electric motor, having the following characteristics:
- a circuit carrier (ST) having a surface (OF);
- at least two first contact surfaces (KF11, KF12) on the surface (OF), on which first contact surfaces respectively a first power transistor (T11, T12) having a body-contact surface is directly arranged and respectively connected in an electrically conductive manner to the respective first contact surface (KF11, KF12) via the body-contact surface thereof;
- a second contact surface (KF2) on the surface (OF), on which second contact surface at least two second power transistors (T21, T22) having a body-contact surface are directly arranged and respectively connected in an electrically conductive manner to the second contact surface (KF2) via the body-contact surfaces thereof;
- at least two third contact surfaces (KF31, KF32) on the surface (OF), wherein the at least two second power transistors (T21, T22) respectively have a two-dimensionally extended reverse side contact (S21, S22) via which they are respectively connected in an electrically conductive manner to one of the at least two third contact surfaces (KF31, KF32);
- wherein the at least two first (KF11, KF12) and the at least two third (KF31, KF32) contact surfaces are arranged alternatingly, one after the other, in a reference direction (LR) of the power module, and the second contact surface (KF2) is arranged next to the at least two first (KF11, KF12) and the at least two third (KF31, KF32) contact surfaces,
**characterized in that**
- the power module (LM, LM') further comprises at least one connecting surface (VF2) on the surface (OF), which, as a protrusion on one of the at least two third contact surfaces (KF31), extends away from the corresponding third contact surface (KF31) up to another of the at least two third contact surfaces (KF32) and directly interconnects said two third contact surfaces (KF31, KF32) in an electrically conductive manner;
- wherein the at least one connecting surface (VF2) and the at least two third contact surfaces (KF31, KF32) are mutually configured in a one-piece arrangement.

2. Power module (LM, LM') according to Claim 1, wherein in each case one of the at least two second power transistors (T21, T22) is arranged respectively next to one of the at least two third contact surfaces (KF31, KF32) .

3. Power module (LM, LM') according to Claim 1 or 2,
- wherein the second contact surface (KF2) has at least two contact regions (B21, B22);
- wherein respectively one of the at least two contact regions (B21, B22) is located respectively next to one of the at least two first power transistors (T11, T12), and the at least two first power transistors (T11, T12) respectively have a two-dimensionally extended reverse side contact (S11, S12) via which they are respectively connected in an electrically conductive manner to one of the at least two contact regions (B21, B22).

4. Power module (LM, LM') according to Claim 3, wherein the at least two first contact regions (B21, B22) and the at least two second power transistors (T21, T22) are arranged alternatingly, one after the other, in the reference direction (LR) of the power module.

5. Power module (LM') according to one of the preceding claims, further comprising a fourth contact surface (KF4) on the surface (OF), which, as a protrusion on the second contact surface (KF2), extends away from the second contact surface (KF2) in the direction of the at least one connecting surface (VF2).

6. Power module (LM, LM') according to Claim 5, wherein the second (KF2) and the fourth (KF4) contact surface are mutually configured in a one-piece arrangement.

7. Power module group (LG), specifically for the delivery of a phase current to an electric motor, having the following characteristics:
- at least two power modules (LM, LM') according to one of the preceding claims;
- a first conductor rail (SS1), which is directly connected in an electrically conductive manner to the respective second contact surfaces (KF2) of the at least two power modules (LM, LM') and mechanically interconnects the at least two power modules (LM, LM').

8. Power module group (LG) according to Claim 7, further comprising a second conductor rail (SS2), which is directly connected in an electrically conductive manner to the respective first contact surfaces (KF11, KF12) of the at least two power modules (LM, LM') and which mechanically interconnects the at least two power modules (LM, LM').

9. Power module group (LG) according to Claim 7 or 8, further comprising a third conductor rail (SS3), which is connected in an electrically conductive manner to the respective third contact surfaces (KF31, KF32) of the at least two power modules (LM, LM') and which mechanically interconnects the at least two power modules (LM, LM').

10. Power module group (LG) according to one of Claims 7 to 9, further comprising at least one electrical connection (BD), which connects a connecting surface (VF2) of one of the at least two power modules (LM) directly to one of the third contact surfaces (KF32) of another of the at least two power modules (LM') in an electrically conductive manner.

11. Power output stage (LS), specifically for the delivery of phase currents for current phases of an electric motor, having the following characteristics:
- at least three power module groups (LG) according to one of Claims 7 to 10;
- a power capacitor (C) having a first electrode terminal and a second electrode terminal and connected via the first electrode terminal to the respective second conductor rails (SS2) of the at least three power module groups (LG) and via the second electrode terminal to the respective third conductor rails (SS3) of the at least three power module groups (LG) in an electrically conductive manner.

12. Drive system for driving a vehicle, which comprises at least one electric motor for driving the vehicle and at least one power output stage (LS) according to Claim 11 for the delivery of phase currents to the at least one electric motor.

## Revendications

1. Module de puissance (LM, LM'), en particulier pour la fourniture d'un courant de phase destiné à un moteur électrique, présentant les caractéristiques suivantes :
- un support de circuit (ST) pourvu d'une surface (OF) ;
- au moins deux premières surfaces de contact (KF11, KF12) sur la surface (OF), sur chacune desquelles est disposé directement un premier transistor de puissance (T11, T12) présentant une surface de contact au sol, qui est reliée de manière électriquement conductrice par sa surface de contact au sol à la première surface de contact respective (KF11, KF12),
- une deuxième surface de contact (KF2) sur la surface (OF), sur laquelle sont disposés directement au moins deux deuxièmes transistors de puissance (T21, T22) présentant une surface de contact au sol, lesquels sont reliés chacun de manière électriquement conductrice à la deuxième surface de contact (KF2) par le biais de leur surface de contact au sol ;
- au moins deux troisièmes surfaces de contact (KF31, KF32) sur la surface (OF), dans lequel les au moins deux deuxièmes transistors de puissance (T21, T22) présentent chacun un contact arrière (S21, S22) qui s'étend à plat et par le biais duquel ils sont reliés chacun de manière électriquement conductrice à l'une des au moins deux troisièmes surfaces de contact (KF31, KF32) ;
- dans lequel les au moins deux premières (KF11, KF12) et les au moins deux troisièmes (KF31, KF32) surfaces de contact sont disposées en alternance l'une après l'autre dans une direction de référence (LR) du module de puissance, et la deuxième surface de contact (KF2) est disposée à côté des au moins deux premières (KF11, KF12) et des au moins deux troisièmes (KF31, KF32) surfaces de contact,
**caractérisé en ce que**
- le module de puissance (LM, LM') comprend en outre sur la surface (OF) au moins une surface de connexion (VF2) qui s'étend en saillie sur l'une des au moins deux troisièmes surfaces de contact (KF31) en s'écartant de la troisième surface de contact correspondante (KF31) jusqu'à une autre des au moins deux troisièmes surfaces de contact (KF32) et relie directement l'une à l'autre de manière électriquement conductrice ces deux troisièmes surfaces de contact (KF31, KF32) ;
- dans lequel l'au moins une surface de connexion (VF2) et les au moins deux troisièmes surfaces de contact (KF31, KF32) sont réalisées de manière solidaire les unes des autres.

2. Module de puissance (LM, LM') selon la revendication 1, dans lequel chacun de l'un des au moins deux deuxièmes transistors de puissance (T21, T22) est disposé à côté de chacune de l'une des au moins deux troisièmes surfaces de contact (KF31, KF32).

3. Module de puissance (LM, LM') selon la revendication 1 ou 2,
- dans lequel la deuxième surface de contact (KF2) présente au moins deux zones de contact (B21, B22) ;
- dans lequel chacune des au moins deux zones de contact (B21, B22) se trouve à côté de chacun de l'un des au moins deux premiers transistors de puissance (T11, T12) et les au moins deux premiers transistors de puissance (T11, T12) présentent chacun un contact arrière (S11, S12) s'étendant à plat, par le biais duquel ils sont chacun reliés de manière électriquement conductrice à l'une des au moins deux zones de contact (B21, B22).

4. Module de puissance (LM, LM') selon la revendication 3, dans lequel les au moins deux premières zones de contact (B21, B22) et les au moins deux deuxièmes transistors de puissance (T21, T22) sont disposés en alternance l'un après l'autre dans la direction de référence (LR) du module de puissance.

5. Module de puissance (LM') selon l'une quelconque des revendications précédentes, comprenant en outre sur la surface (OF) une quatrième surface de contact (KF4) qui s'étend en saillie sur la deuxième surface de contact (KF2) en s'écartant de la deuxième surface de contact (KF2) en direction de l'au moins une surface de connexion (VF2) .

6. Module de puissance (LM, LM') selon la revendication 5, dans lequel les deuxième (KF2) et quatrième (KF4) surfaces de contact sont réalisées de manière solidaire l'une de l'autre.

7. Groupe de modules de puissance (LG), en particulier pour la fourniture d'un courant de phase destiné à un moteur électrique, présentant les caractéristiques suivantes :
- au moins deux modules de puissance (LM, LM') selon l'une quelconque des revendications précédentes ;
- une première barre omnibus (SS1) qui est directement reliée de manière électriquement conductrice aux deuxièmes surfaces de contact (KF2) respectives des au moins deux modules de puissance (LM, LM') et qui relie mécaniquement les uns aux autres les au moins deux modules de puissance (LM, LM').

8. Groupe de modules de puissance (LG) selon la revendication 7, comprenant en outre une deuxième barre omnibus (SS2) qui est directement reliée de manière électriquement conductrice aux premières surfaces de contact respectives (KF11, KF12) des au moins deux modules de puissance (LM, LM') et relie mécaniquement les uns aux autres les au moins deux modules de puissance (LM, LM').

9. Groupe de modules de puissance (LG) selon la revendication 7 ou 8, comprenant en outre une troisième barre omnibus (SS3) qui est reliée de manière électriquement conductrice aux troisièmes surfaces de contact respectives (KF31, KF32) des au moins deux modules de puissance (LM, LM') et relie mécaniquement les uns aux autres les au moins deux modules de puissance (LM, LM').

10. Groupe de modules de puissance (LG) selon l'une quelconque des revendications 7 à 9, comprenant en outre au moins une connexion électrique (BD) qui relie directement de manière électriquement conductrice la première surface de connexion (VF2) de l'un des au moins deux modules de puissance (LM) à l'une des troisièmes surfaces de contact (KF32) d'un autre des au moins deux modules de puissance (LM').

11. Étage final de puissance (LS), en particulier pour la fourniture de courants de phase destinés à des phases de courant d'un moteur électrique, présentant les caractéristiques suivantes :
- au moins trois groupes de modules de puissance (LG) selon l'une quelconque des revendications 7 à 10 ;
- un condensateur de puissance (C) qui présente une première borne d'électrode et une deuxième borne d'électrode et qui est relié de manière électriquement conductrice par le biais de la première borne d'électrode aux deuxièmes barres omnibus respectives (SS2) des au moins trois groupes de modules de puissance (LG) et par le biais de la deuxième borne d'électrode aux troisièmes barres omnibus respectives (SS3) des au moins trois groupes de modules de puissance (LG).

12. Système d'entraînement pour l'entraînement d'un véhicule, lequel système d'entraînement comprend au moins un moteur électrique pour l'entraînement du véhicule et au moins un étage final de puissance (LS) selon la revendication 11 pour la fourniture de courants de phase destinés à l'au moins un moteur électrique.
